# EUROPÄISCHE PATENTSCHRIFT

(11) **EP 2 173 921 B1**
(45) Veröffentlichungstag und Bekanntmachung des Hinweises auf die Patenterteilung: **18.05.2011**
(21) Anmeldenummer: 08784919.6
(22) Anmeldetag: 21.07.2008
(51) Int. Cl.: C23C 14/26, C23C 14/24, C23C 14/30, C30B 23/06

(54) **HOCHTEMPERATUR-VERDAMPFERZELLE MIT PARALLEL GESCHALTETEN HEIZBEREICHEN**
HIGH TEMPERATURE EVAPORATOR CELL HAVING PARALLEL-CONNECTED HEATING ZONES
CELLULE D'ÉVAPORATION À HAUTE TEMPÉRATURE AVEC DES ZONES CHAUFFANTES MONTÉES EN PARALLÈLE

(30) Priorität: 27.07.2007 DE 102007035166
(43) Veröffentlichungstag der Anmeldung: 14.04.2010
(60) Teilanmeldung: 10015785.8
(73) Patentinhaber: CreaTec Fischer & Co. GmbH, 74391 Erligheim (DE); Forschungsverbund Berlin E.V., 12489 Berlin (DE)
(72) Erfinder: BRAUN, Wolfgang, 13349 Berlin (DE); FISCHER, Albrecht, 74369 Löchgau (DE); WATAHIKI, Tatsuro, 10625 Berlin (DE)
(74) Vertreter: Hertz, Oliver
(86) Internationale Anmeldenummer: PCT/EP2008/005953
(87) Internationale Veröffentlichungsnummer: WO 2009/015796

(56) Entgegenhaltungen:
- DE-A1- 4 106 579
- DE-A1-102005 025 935
- JP-A- 2005 194 552
- US-A- 5 522 955

## Beschreibung

Die Erfindung betrifft eine Verdampferzelle mit den Merkmalen des Oberbegriffs von Anspruch 1, insbesondere eine Effusions-Verdampferzelle zur Überführung eines Verdampfungsguts in die Gasphase (Verdampfung, Sublimation), und ein Verfahren zur Verdampfung von Verdampfungsgut mit einer derartigen Verdampferzelle.

Die Verdampfung von Materialien zur Abscheidung dünner Schichten ist ein verbreitetes Verfahren, z. B. in der technischen Physik und in der Halbleitertechnik. Bei der Verwendung von hochschmelzenden Materialien, die erst bei extrem hohen Temperaturen (oberhalb von z. B. 1800°C, insbesondere oberhalb von 2000°C) in die Gasphase übergehen, gibt es besondere Anforderungen insbesondere an die Temperaturstabilität und die Einstellung der Verdampfungsrate bei der Verdampfung. Des Weiteren besteht z. B. bei der Herstellung von Dünnschicht-Bauelementen für die CMOS-Technik ein Interesse an einer gut steuerbaren und reproduzierbaren, nichtreaktiven Dampfabscheidung von Isolatorschichten, bei der das Verdampfungsgut die gewünschte stöchiometrische Zusammensetzung der Isolatorschichten aufweist.

In DE 10 2005 025 935 A1 wird eine Verdampferzelle beschrieben, die einen Tiegel zur Aufnahme von Verdampfungsgut und einen Heizwiderstand umfasst, der sowohl für eine Widerstandsheizung und als auch für eine Elektronenstrahlheizung des Tiegels angeordnet ist. Der Heizwiderstand umfasst eine Heizwendel, die den Tiegel allseitig umgibt, mit Heizelementen, die sich entlang der axialen Ausrichtung des Tiegels erstrecken. Die Heizwendel ist mit elektrischen Isolatoren an einer Abschirmung befestigt, die den Tiegel umgibt. Zur Vermeidung unerwünschter Magnetfelder bei der Beaufschlagung des Heizwiderstands mit einem Betriebsstrom sind die Heizelemente paarweise entgegengesetzt ausgerichtet und in Reihe geschaltet. Für die Steuerung der Widerstandsheizung und der Elektronenstrahlheizung sind Regelkreise vorgesehen, die mit einem Temperatursensor verbunden sind.

Mit der Verdampferzelle gemäß DE 10 2005 025 935 A1 wird ein stufenloser Übergang von der Widerstandsheizung zur Elektronenstrahlheizung ermöglicht, so dass die Temperatur des Verdampfungsguts in einem großen Temperaturbereich eingestellt werden kann. Beispielsweise ist in einem niedrigeren Temperaturbereich eine Reinigung des Materials und in einem höheren Temperaturbereich die Überführung des Materials in die Gasphase vorgesehen.

Mit der herkömmlichen Verdampferzelle können die folgenden Probleme auftreten. Die elektrischen Isolatoren zur Befestigung der Heizwendel können durch den Betrieb bei hohen Temperaturen beschädigt werden. Bei Funktionsverlust eines Isolators kann ein Kurzschluss auftreten, durch den die gesamte Verdampferzelle ausfällt. Des Weiteren können Variationen des elektrischen Widerstands entlang der Länge der Heizwendel auftreten. Die Variationen können eine ungleichförmige Erwärmung des Verdampfungsguts im Tiegel ergeben. Die genannten Probleme treten insbesondere bei hohen Temperaturen im Bereich von zum Beispiel 2200 bis 2500 °C auf. Ferner kann sich eine inhomogene Heizwirkung bilden, da sich der Tiegel trotz gleichförmiger Energiezufuhr vom Boden zur Tiegelöffnung hin tendenziell weniger stark erwärmt.

Ein weiterer Nachteil der herkömmlichen Verdampferzelle ergibt sich daraus, dass zur Verbesserung eines störungsfreien Betriebs ohne eine gegenseitige Beeinflussung der Widerstands- und Elektronenstrahlheizungen zwei Regelkreise realisiert werden. Dies kann wegen der Komplexität des Aufbaus und erhöhter Kosten von Nachteil sein. Schließlich hat sich beim Dauerbetrieb der herkömmlichen Verdampferzelle gezeigt, dass der für die Regelung verwendete Temperatursensor unter der Wirkung der hohen Betriebstemperatur ausfallen kann. Nach einem Sensorausfall kann eine aufwendige Demontage der Verdampferzelle erforderlich sein.

Die Aufgabe der Erfindung ist es, eine verbesserte Verdampferzelle zur Überführung insbesondere von hochschmelzenden Materialien in die Gasphase, insbesondere eine verbesserte Effusionszelle bereitzustellen, mit der Nachteile der herkömmlichen Verdampferzelle überwunden werden und die insbesondere einen dauerhaften und zuverlässigen Betrieb bei hohen Temperaturen, z. B. oberhalb von 1900°C ermöglicht. Die Aufgabe der Erfindung besteht auch in der Bereitstellung eines verbesserten Verfahrens zur Verdampfung insbesondere von hochschmelzenden Materialien, mit dem Nachteile herkömmlicher Techniken überwunden werden.

Diese Aufgaben werden durch eine Verdampferzelle und ein Verdampfungsverfahren mit den Merkmalen der unabhängigen Ansprüche gelöst. Vorteilhafte Ausführungsformen und Anwendungen der Erfindung ergeben sich aus den abhängigen Ansprüchen.

Vorrichtungsbezogen basiert die Erfindung auf der allgemeinen technischen Lehre, eine Verdampferzelle mit einem Tiegel und einem Heizwiderstand bereitzustellen, der eine Vielzahl von Heizbereichen zur Widerstands- und Elektronenstrahlheizung des Tiegels umfasst. Im Unterschied zu der herkömmlichen Verwendung einer Heizwendel mit in Reihe geschalteten Heizelementen bilden die Heizbereiche der erfindungsgemäßen Verdampferzelle auf einer Außenseite des Tiegels eine elektrische Parallelschaltung. Die Heizbereiche sind dazu vorgesehen, elektrisch parallel an Anschlüsse einer Spannungsversorgung für die Widerstands- und Elektronenstrahlheizung angeschlossen zu werden. Der Tiegel weist eine Axialrichtung auf, die einer Verbindungslinie zwischen einem Tiegelboden und einer Tiegelöffnung entspricht. Die Parallelschaltung erstreckt sich in der Axialrichtung des Tiegels. Bei Beaufschlagung der Heizbereiche mit einer Heizspannung fließt ein Heizstrom parallel und gleichsinnig durch alle Heizbereiche.

Die Parallelschaltung der Heizbereiche bietet eine Reihe von Vorteilen. Erstens wird an jedem der Anschlüsse, z. B. beim Tiegelboden oder bei der Tiegelöffnung, nur ein Kontakt zur Verbindung der Heizbereiche mit der Spannungsversorgungseinrichtung benötigt. Die Befestigung der Heizeinrichtung auf der Außenseite des Tiegels wird vereinfacht. Die Befestigung kann insbesondere realisiert werden, ohne dass elektrische Isolatoren in Bereichen besonders hoher Temperatur, d.h. nahe der Tiegelöffnung erforderlich sind. Des weiteren werden eventuelle Variationen des elektrischen Widerstandes im Material der Heizbereiche durch die Parallelschaltung ausgeglichen. Somit ergibt sich eine erhöhte Gleichförmigkeit der Tiegelheizung. Schließlich haben die Erfinder festgestellt, dass die Vermeidung unerwünschter Magnetfelder nicht nur mit der herkömmlichen Heizwendel, sondern auch mit der Parallelschaltung der Heizbereiche erzielt werden kann, in dem an der Verdampferzelle Bereiche mit einer Stromrichtung bereitgestellt werden, die zu der Stromrichtung in den Heizbereichen umgekehrt ist. Dies kann zum Beispiel mit Teilen einer Abschirmeinrichtung (siehe unten) oder einem zusätzlichen Leiter realisiert werden.

Verfahrensbezogen basiert die Erfindung auf der allgemeinen technischen Lehre, Verdampfungsgut in einem Tiegel einer Verdampferzelle einer indirekten Heizung mit einer außerhalb des Tiegels angeordneten Gruppe von parallel geschalteten Heizbereichen zu unterziehen, die in einem ersten Temperaturbereich eine Widerstandsheizung und in einem zweiten Temperaturbereich eine Elektronenstrahlheizung des Tiegels bilden.

Vorzugsweise wird Verdampfungsgut verdampft, das ein hochschmelzendes Material umfasst. Hochschmelzendes Material zeichnet sich durch einen Schmelzpunkt oberhalb von 1500°C, insbesondere oberhalb von 2000°C aus.

Ein besonderer Vorteil der Erfindung besteht darin, dass die Verdampferzelle im Vergleich zur herkömmlichen Verdampferzelle einen vereinfachten Aufbau aufweist und einen zuverlässigen Dauerbetrieb ermöglicht, ohne dass die hervorragenden Eigenschaften der Verdampferzelle insbesondere in Bezug auf die Temperatureinstellung beeinträchtigt werden.

Die erfindungsgemäße Verdampferzelle stellt vorzugsweise eine Effusionszelle dar. Sie ist insbesondere zur genauen und reproduzierbaren Abscheidung von Schichten aus hochschmelzenden Materialien, z. B. in der Halbleitertechnik geeignet. Mit der Verdampferzelle werden Temperaturen oberhalb von 2000 °C, z. B. oberhalb von 2300 °C, insbesondere bis nahezu 3000 °C, z. B. bis 2900 °C erreicht. Ein weiterer Vorteil der Erfindung besteht darin, dass mit einer einzigen Heizeinrichtung der erfindungsgemäße Verdampferzelle eine Temperatureinstellung in einem Temperaturbereich ermöglicht wird, der von Raumtemperatur (oder sogar darunter) bis zu den genannten hohen Temperaturen reicht.

Die erfindungsgemäße Verdampferzelle weist einen erweiterten Anwendungsbereich auf. Sie kann bspw. zum Dauerbetrieb gemeinsam mit einer Vielzahl weiterer Verdampferzellen in einer Beschichtungsanlage verwendet werden, wobei die Verdampferzellen ohne eine gegenseitige Beeinflussung gesteuert werden können und einen geringen Wartungsaufwand aufweisen.

Im Folgenden wird das zu bearbeitende Material unabhängig von der konkreten Aufgabe der Verdampferzelle und unabhängig von der Art des Phasenübergangs als Verdampfung oder Sublimation als "Verdampfungsgut" bezeichnet. Entsprechend wird der Übergang in die Gasphase im Folgenden unabhängig von der Tatsache, ob im konkreten Fall eine Verdampfung aus der Schmelze oder eine Sublimation aus dem Festzustand erfolgt, als "Verdampfung" bezeichnet.

Die parallel geschalteten Heizbereiche zur kombinierten Widerstandsheizung und Elektronenstrahlheizung erstrecken sich gemäß der Erfindung auf mehreren Seiten des Tiegels, so dass vorteilhafterweise die Genauigkeit und Reproduzierbarkeit der Temperatureinstellung verbessert werden kann. Der Tiegel umfasst typischerweise den Tiegelboden und eine Seitenwand, die einen Innenraum des Tiegels einschließt. Gemäß bevorzugten Merkmalen kann der Tiegel die Form eines Zylinders, z. B. mit einer kreisförmigen oder elliptischen Grundfläche oder die Form eines Konus aufweisen. Die Verteilung der Heizbereiche auf mehreren Seiten des Tiegels bedeutet, dass die Heizbereiche (oder Heizwiderstandsabschnitte) auf der Außenseite der Seitenwand verteilt angeordnet sind. Insbesondere zur Verdampfung größerer Mengen von Verdampfungsgut ist vorzugsweise vorgesehen, dass der Tiegel eine lang gestreckte Form aufweist. Die charakteristische Größe (z. B. der Durchmesser) des Tiegelbodens ist geringer als die Ausdehnung (z. B. Höhe der Seitenwände). Erfindungsgemäß erstrecken sich die Heizbereiche entlang der Längsausdehnung (Axialrichtung) auf der Außenseite des Tiegels.

Gemäß einer ersten Ausführungsform der Erfindung umfassen die Heizbereiche Heizelemente, die entlang der Axialrichtung des Tiegels voneinander getrennt verlaufen. Die Heizelemente sind zwischen den in Axialrichtungen beabstandet angeordneten Anschlüssen des Heizwiderstandes parallel geschaltet. Die Verwendung der voneinander beabstandet angeordneten Heizelemente hat den Vorteil, dass während des Betriebs der Verdampferzelle eine Beobachtung des Tiegels, z.B. für Zwecke der Überwachung oder der Temperaturmessung mit optischen Mitteln ermöglicht wird. Des weiteren ermöglichen die Heizelemente die Bereitstellung eines relativ hohen Widerstandswertes des Heizwiderstands. Schließlich wird mit jedem Heizelement, das vorzugsweise entlang der Axialrichtung des Tiegels mit einem konstanten Querschnitt gebildet ist, ein konstanter Widerstand pro Länge bereitgestellt. Vorteilhafterweise kann somit eine in der Axialrichtung des Tiegels konstante Heizleistung erzeugt werden.

Gemäß einer bevorzugten Variante der ersten Ausführungsform der Erfindung weist die Heizeinrichtung einen oberen Ringleiter auf, an dem die Heizelemente (oder: Heizleiter) parallel angeschlossen sind. Der obere Ringleiter umfasst allgemein einen elektrischen Leiter, der den Tiegel an einem oberen Ende, d.h. an dem Ende mit der Tiegelöffnung umgibt. Mit dem oberen Ringleiter sind alle Heizelemente mit einem ersten (oberen) Ende verbunden.

Die Anordnung des oberen Ringleiters bei der Tiegelöffnung bedeutet, das der obere Ringleiter mit einem radialen Abstand die Tiegelöffnung azimutal umgibt. Alternativ kann der obere Ringleiter mit einem axialen Abstand vor der Tiegelöffnung angeordnet sein. Zur Vermeidung eines Niederschlags von Verdampfungsgut auf dem oberen Ringleiter ist dieser allerdings vorzugsweise außerhalb der Verdampfungscharakteristik des Tiegels angeordnet. Gemäß einer weiteren Alternative kann der obere Ringleiter mit einem Abstand entgegengesetzt zur Verdampfungsrichtung die Seitenwand des Tiegels hinter der Tiegelöffnung umgeben. Dies ist insbesondere dann möglich, wenn die Gefahr eines Niederschlags von Verdampfungsgut an der Tiegelöffnung gering ist. An die Form des Ringleiters werden keine besonderen Anforderungen gestellt. Er kann beispielsweise die gleiche Form wie die Querschnittsform des Tiegels (z. B. kreisförmig, elliptisch) oder alternativ eine andere Form mit geraden oder gekrümmten Leiterabschnitten (z. B. mehreckig) haben.

Der obere Ringleiter ist dazu vorgesehen, mit einem ersten Potential beaufschlagt zu werden. Der obere Ringleiter ist vorzugsweise mit dem negativen Pol der Spannungsversorgungseinrichtung, insbesondere mit dem negativen Pol der Stromquelle für die Widerstandsheizung und der Hochspannungsquelle für die Elektronenstrahlheizung verbunden.

Gemäß einer weiteren bevorzugten Variante der ersten Ausführungsform der Erfindung weist die Heizeinrichtung einen unteren Ringleiter auf, an dem die Heizelemente parallel angeschlossen sind. Die zweiten (unteren) Enden der Heizelemente sind mit dem unteren Ringleiter verbunden. Der untere Ringleiter ist dazu eingerichtet, mit einem zweiten Potential beaufschlagt zu werden. Der untere Ringleiter umfasst allgemein einen elektrischen Leiter, der den Tiegel an einem unteren Ende, d. h. an dem Ende mit dem Tiegelboden umgibt. Vorzugsweise weist der untere Ringleiter die gleiche axiale Position wie der Tiegelboden auf. Alternativ kann er mit einem axialen Abstand unterhalb des Tiegelbodens angeordnet sein, wobei er eine Halterungseinrichtung des Tiegels umgibt. In diesem Fall kann die zuverlässige Heizung des gesamten Tiegelbodens verbessert werden. Gemäß einer weiteren Alternative kann der untere Ringleiter vom Tiegelboden in Verdampfungsrichtung, d.h. in Richtung hin zur Verdampfungsöffnung versetzt angeordnet sein, wenn an die Heizung des Tiegelbodens geringere Anforderungen gestellt werden.

Erfindungsgemäß kann der obere Ringleiter oder der untere Ringleiter vorgesehen sein, um das gemeinsame Potential für die oberen oder unteren Enden der Heizelemente bereitzustellen. In diesem Fall sind die anderen Enden der Heizelemente, d. h. die unteren oder die oberen Enden der Heizelemente nicht mit einem gemeinsamen Leiter, sondern über getrennte Leiter mit einem Pol der Strom- und Hochspannungsquellen verbunden. Die Bereitstellung von nur einem der oberen und unteren Ringleiter kann in Abhängigkeit von der konkreten Bauform der Verdampferzelle von Vorteil sein.

Besonders bevorzugt ist jedoch eine Variante der ersten Ausführungsform der Erfindung, bei welcher der obere Ringleiter und der untere Ringleiter vorgesehen sind, zwischen denen sich die Heizelemente erstrecken. Vorteilhafterweise wird damit eine besonders stabile Anordnung der Heizelemente erzielt. Die Ringleiter übernehmen wegen der Bereitstellung des gemeinsamen Potentials für die Heizelemente und der Halterung der Heizelemente eine mechanische und elektrische Doppelfunktion.

Gemäß einer zweiten Ausführungsform der Erfindung können sich die Heizbereiche in Umfangsrichtung des Tiegels gegenseitig berühren. Die Heizbereiche sind zu einem flächigen Widerstandsmaterial verbunden, das den Tiegel teilweise oder radial allseitig umgibt. Die Heizbereiche bilden vorzugsweise eine Widerstandshülse (Heizfolie), die den Tiegel radial allseitig umgibt. Die Form der Widerstandshülse kann beispielsweise zylinder- oder konusförmig gebildet sein.

Durch eine konische Form der Widerstandshülse kann vorteilhafterweise bevorzugt ein vorderer oder hinterer Teil des Tiegels erwärmt werden. Bei konstantem Strom durch die Hülse und bei konstanter Dicke des Hülsenmaterials (z. B. 10 µm) wird die Hülse an ihrem geringsten Querschnitt am stärksten erwärmt. Diese Eigenschaft der Hülse ist ein wesentlicher Vorteil, da diese Temperaturvariation mit einzelnen Filamenten konstanten Querschnitts nicht erreichbar ist.

Bei der zweiten Ausführungsform der Erfindung bilden die Heizbereiche einen einzigen, den Tiegel umgebenden, flächigen Heizleiter. Die zweite Ausführungsform der Erfindung hat den besonderen Vorteil, dass das flächige Widerstandsmaterial eine im Vergleich zu den einzelnen, voneinander beabstandeten Heizelementen (o. g. erste Ausführungsform) erhöhte Stabilität aufweist. Mit der erhöhten Stabilität wird eine verbesserte Homogenität der Erwärmung des Tiegels, insbesondere bei der Elektronenstrahlheizung erzielt.

Gemäß einer bevorzugten Variante der zweiten Ausführungsform der Erfindung weist das flächige Widerstandsmaterial, insbesondere die Widerstandshülse in der Axialrichtung des Tiegels eine konstante Dicke auf. Diese Variante ist insbesondere bei Verwendung einer konusförmigen Widerstandshülse von Vorteil. Die konusförmige Widerstandshülse weist eine sich von der Tiegelöffnung zum Tiegelboden verringernde Querschnittsdimension auf. Wegen der in Axial- und Azimutalrichtung konstanten Dicke des Widerstandsmaterials nimmt der integrierte Querschnitt der Widerstandshülse von der Tiegelöffnung zum Tiegelboden ab. Somit ist von der Tiegelöffnung zum Tiegelboden ein zunehmender elektrischer Widerstand gegeben (Widerstandsgradient). Daher kann in Axialrichtung des Tiegels von der Tiegelöffnung zum Tiegelboden ein Gradient der Heizleistung realisiert werden.

Gemäß einem weiteren vorteilhaften Merkmal der Erfindung weist die Widerstandshülse an ihrem oberen Rand, der die Tiegelöffnung umgibt, und/oder an ihrem unteren Rand, der den Tiegelboden umgibt, in radialer Richtung nach außen gebogene oder geknickte Streifen auf, die zur Befestigung der Widerstandshülse jeweils entsprechend an einem oberen und/oder unteren Ringleiter und zum Ausgleich thermischer Änderungen der Länge der Widerstandshülse vorgesehen sind.

Typischerweise hat der Tiegel an der Tiegelöffnung durch Abstrahlung einen stärkeren Wärmeverlust als am Tiegelboden. Dadurch entsteht bei konstanter Heizleistung ein Temperaturgradient, der in Abhängigkeit von der konkreten Anwendung, insbesondere in Abhängigkeit von dem verdampften Material unerwünscht sein kann. Die Bildung eines Gradienten der Heizleistung kann vorteilhafterweise genutzt werden, um den Temperaturgradienten zu kompensieren oder in vorbestimmter Weise einzustellen.

Der genannte Widerstandsgradient wirkt sich besonders vorteilhaft bei der Elektronenstrahlheizung aus. Wenn negatives Potential am oberen Ende der Widerstandshülse nahe der Tiegelöffnung anliegt, erfahren injizierte Elektronen den elektrischen Widerstand einerseits der Vakuumstrecke zum Tiegel und andererseits des Stromweges durch die Widerstandshülse. Mit dem Widerstandsgradienten kann sich das Verhältnis beider Widerstandswerte in Axialrichtung des Tiegels verändern. Nahe der Tiegelöffnung erfolgt eine stärkere Elektronenstrahlheizung als nahe dem Tiegelboden so dass der Temperaturgradient eingestellt werden kann, um die Strahlungsverluste am oberen Tiegelende zu kompensieren.

Gemäß einer besonders bevorzugten Variante der zweiten Ausführungsform der Erfindung bilden die Heizbereiche eine Metallfolie, die sich zwischen Anschlüssen des Heizwiderstands erstreckt, die in Axialrichtung des Tiegels auf dessen Außenseite voneinander beabstandet angeordnet sind. Die Metallfolie hat vorzugsweise eine Dicke im Bereich von 5 µm bis 50 µm, insbesondere 15 µm bis 50 µm oder bevorzugt 5 µm bis 30 µm, z. B. 5 µm bis 8 µm.

Gemäß einer weiteren Variante der zweiten Ausführungsform der Erfindung können der obere Ringleiter und/oder der untere Ringleiter, die oben in Zusammenhang mit der ersten Ausführungsform der Erfindung beschrieben wurden, auch an der Widerstandshülse vorgesehen sein. Der obere Ringleiter und/oder der untere Ringleiter können z. B. an den Enden der Widerstandshülse auf deren Außenseite oder auf deren Randkante befestigt, z. B. angeschweißt sein.

Erfindungsgemäß können Heizbereiche, die getrennte Heizelemente umfassen, und Heizbereiche, die zu einem flächigen Widerstandsmaterial verbunden sind und den Tiegel teilweise umgeben, kombiniert werden. In diesem Fall können sich Vorteile für die Bereitstellung einer bestimmten Verteilung der Heizleistung am Tiegel ergeben.

Da die Parallelschaltung der Heizbereiche deren Halterung am Tiegel vereinfacht, kann gemäß einer weiteren Variante der Erfindung vorgesehen sein, dass der Heizwiderstand über einen elektrischen Isolator mit dem Tiegel fest verbunden ist. Der elektrische Isolator, der eine Vielzahl von Isolatorelementen oder bevorzugt einen einzigen Isolatorring umfasst, ist auf einer Außenseite des Tiegels vorzugsweise in einem Teilbereich angeordnet, in dem eine geringere Temperatur als in anderen Bereichen des Tiegels herrscht.

Bei Bereitstellung des unteren Ringleiters (o. g. erste Ausführungsform) wird dieser vorzugsweise an dem elektrischen Isolator angebracht, der mit dem Tiegel, insbesondere dem Tiegelboden fest verbunden ist. Durch die Kombination des elektrischen Isolators mit dem unteren Ringleiter wird eine zuverlässige Halterung der Heizelemente gebildet. Bei Bereitstellung des flächigen Widerstandsmaterials (o. g. zweite Ausführungsform) wird dessen unterer Rand an dem elektrischen Isolator befestigt.

Vorteilhafterweise kann die thermische Belastung des elektrischen Isolators noch vermindert werden, wenn dieser an einer Halteeinrichtung des Tiegels, d.h. relativ zu der axialen Bezugsrichtung des Tiegels unterhalb des Tiegelbodens befestigt ist. Der untere Ringleiter oder der untere Rand des flächigen Widerstandsmaterials ist in diesem Fall über einen Ringhalter mit dem elektrischen Isolator verbunden. Der Ringhalter überbrückt den Abstand zwischen dem Heizwiderstand am Tiegelboden und der Position des elektrischen Isolators an der Halteeinrichtung.

Der Ringhalter kann einen mechanischen Träger des Heizwiderstands bilden. In diesem Fall besteht er aus einem elektrisch isolierenden Material. Alternativ kann der Ringhalter eine elektrische Leitung zur Beaufschlagung des Heizwiderstands mit dem zweiten Potential bilden. In diesem Fall besteht der Ringhalter aus einem elektrisch leitfähigen Material, wobei sich der integrierte Materialquerschnitt des Ringhalters vorzugsweise von dem Durchmesser der Heizelemente oder der Dicke der Widerstandshülse so unterscheidet, dass bei der Widerstandsheizung ein geringer elektrischer Widerstand und somit praktisch keine Aufheizung und bei der Elektronenstrahlheizung praktisch keine Elektronenemission realisiert werden. Der Ringhalter kann z. B. einen Ring aus einer Metallfolie oder einem Blech, Haltestifte oder Stanz- oder Frästeile umfassen.

Die Bereitstellung des elektrischen Isolators an der Halteeinrichtung hat den Vorteil, dass die Halteeinrichtung nicht nur von der indirekten Heizung ausgenommen ist, sondern sogar aktiv direkt gekühlt werden kann, so dass eine unerwünschte thermische Beanspruchung des elektrischen Isolators ausgeschlossen wird.

Gemäß einer weiteren vorteilhaften Variante der Erfindung weist die Verdampferzelle eine Abschirmeinrichtung mit einer Abschirmwand auf, die den Tiegel in radialer Richtung umgibt. Die Abschirmwand kann vorteilhafterweise mehrere Funktionen erfüllen. Erstens kann eine thermische Abschirmung der Umgebung der Verdampferzelle realisiert werden, was insbesondere für die unabhängige Steuerung von mehreren benachbarten Verdampferzellen in einer Beschichtungsanlage von Vorteil ist. Zweitens kann die Abschirmwand einen mechanischen Träger für die Heizeinrichtung, insbesondere der Heizbereiche und ggf. einen der Ringleiter bilden.

Ein besonderer Vorteil der Erfindung ergibt sich daraus, dass die Heizbereiche mit einem Ende, vorzugsweise mit dem oberen Ende, d.h. in der Umgebung der Tiegelöffnung mit der Abschirmwand elektrisch verbunden sein können. Im Unterschied zu der herkömmlichen Verdampferzelle ist ein elektrischer Isolator im oberen Bereich des Tiegels, insbesondere in der Umgebung der Tiegelöffnung nicht erforderlich. Über die Abschirmwand kann die elektrische Verbindung der oberen Enden der Heizbereiche (ggf. mit dem oberen Ringleiter) mit einem Pol der Stromquelle oder Hochspannungsquelle hergestellt werden. Die Heizbereiche (ggf. der obere Ringleiter oder der obere Rand des flächigen Widerstandsmaterials) können direkt an der Abschirmwand befestigt sein. Damit wird der Aufbau der erfindungsgemäßen Verdampferzelle erheblich vereinfacht.

Gemäß einer weiteren vorteilhaften Variante der Erfindung können die Heizbereiche so angeordnet sein, dass der radiale Abstand der oberen Enden der Heizbereiche vom Tiegel, insbesondere von der Tiegelöffnung größer ist als der radiale Abstand der unteren Enden der Heizbereiche vom Tiegel, insbesondere vom Tiegelboden. Der radiale Abstand der oberen Enden der Heizbereiche von der Tiegelöffnung ist vorzugsweise im Bereich von 1 mm bis 6 mm gewählt. Der radiale Abstand der unteren Enden der Heizbereiche vom Tiegelboden ist vorzugsweise im Bereich von 1 mm bis 4 mm gewählt.

Mit Heizbereichen, die sich in Längsrichtung gerade erstrecken, ergibt sich ein Abstandsgradient von der Tiegelöffnung hin zum Tiegelboden. Durch den abnehmenden radialen Abstand sinkt der Widerstand der Vakuumstrecke von den Heizbereichen zur Seitenwand des Tiegels. Damit kann vorteilhafterweise das oben genannte Verhältnis der Widerstandswerte über die Vakuumstrecke und durch die Heizbereiche zusätzlich beeinflusst werden, um den Temperaturgradienten in Axialrichtung zu kompensieren oder einzustellen und/oder die Temperatur-Emissionsregelung zu beeinflussen.

Alternativ kann vorgesehen sein, dass der Heizwiderstand bei der Tiegelöffnung einen geringeren radialen Abstand von der Seitenwand aufweist als bei dem Tiegelboden. Vorteilhafterweise kann damit die Heizleistung nahe dem Tiegelboden im Vergleich zur Heizleistung nahe der Tiegelöffnung verkleinert werden.

Alternativ oder zusätzlich zu dem Abstandsgradienten kann gemäß einer weiteren vorteilhaften Variante der Erfindung ein Widerstandsgradient vorgesehen sein, mit dem der Ohm'sche Widerstand der Heizbereiche bei der Tiegelöffnung geringer als beim Tiegelboden ist. Der Widerstandsgradient kann beispielsweise bei der zweiten Ausführungsform der Erfindung wie oben beschrieben durch die Konusform des Heizwiderstands oder alternativ durch einen Dickengradienten der Heizbereiche erhalten werden.

Gemäß einer weiteren Alternative eines Widerstandsgradienten kann vorgesehen sein, dass der Heizwiderstand bei der Tiegelöffnung einen größeren Widerstandswert aufweist als bei dem Tiegelboden. Vorteilhafterweise ist damit eine weitere Möglichkeit gegeben, bei Bedarf die Heizleistung nahe dem Tiegelboden geringer einzustellen als die Heizleistung nahe der Tiegelöffnung.

Besonders bevorzugt ist eine Variante der Erfindung, bei der sich die Heizbereiche, insbesondere die Heizelemente zwischen dem oberen Ringleiter und dem unteren Ringleiter oder das flächige Widerstandsmaterial, freitragend erstrecken. Dabei kann der untere Ringleiter oder der untere Rand des flächigen Widerstandsmaterials unmittelbar oder über die genannten Haltestifte am elektrischen Isolator befestigt sein, der am Tiegelboden oder der Halteeinrichtung angeordnet ist, während der obere Ringleiter oder der obere Rand des flächigen Widerstandsmaterials in der Umgebung der Tiegelöffnung an der Innenseite der Abschirmwand befestigt sein kann. Bei einem zylindrischen Aufbau mit einem Tiegel in Form eines geraden Zylinders und einer Abschirmwand in Form einer geraden, zylinderförmigen Hülse wird somit der genannte Abstandsgradient mit dem in Verdampfungsrichtung zunehmenden radialen Abstand der Heizelemente vom Tiegel realisiert.

Gemäß einer weiteren vorteilhaften Variante der Erfindung ist die Verdampferzelle mit mindestens einer Temperaturmesseinrichtung ausgestattet, mit der eine Betriebstemperatur der Verdampferzelle erfassbar ist. Dies bietet insbesondere den Vorteil, dass die Temperaturmessung einfach für verschiedene Messprinzipien eingerichtet werden kann. Vorzugsweise umfasst die Temperaturmesseinrichtung ein Thermoelement, ein Bolometerelement und/oder ein Pyrometerelement. Das Thermoelement hat den Vorteil einer unmittelbaren und kostengünstigen Temperaturmessung, während die optische Temperaturmessung mit Pyrometer- oder Bolometerelementen Vorteile in Bezug auf die berührungslose Messung über relativ große Messabstände haben.

Wegen der einfachen Kalibrierbarkeit und des geringen Platzbedarfs wird jedoch das Thermoelement zur Temperaturmessung bevorzugt. In dem interessierenden Bereich hoher Temperaturen sind Thermoelemente, insbesondere auf der Basis von Wolfram und Rhenium verfügbar (siehe z. B. R. R. Asamoto et al. in "The Review of Scientific Instruments", Bd. 38, 1967, S. 1047). Für die optische Temperaturmessung ist vorzugsweise außerhalb der Verdampferzelle ein Strahlungsdetektor vorgesehen, mit dem ggf. durch ein Sichtfenster oder eine Öffnung in einer Abschirmeinrichtung eine von der Außen- oder Innenwand des Tiegels ausgehende, temperaturabhängige Wärmestrahlung erfassbar ist.

Wenn gemäß einer weiteren Variante der Erfindung das Thermoelement mit einem axialen Abstand unterhalb des Tiegelbodens in der axialen Bezugsrichtung des Tiegels verschiebbar ist, können mehrere Vorteile erzielt werden. Erstens kann durch eine einfache Verschiebung der axiale Abstand des Thermoelements vom Tiegelboden eingestellt und damit an die konkreten Betriebsbedingungen der Verdampferzelle angepasst werden. Des weiteren kann das Thermoelement, z. B. für Zwecke der Wartung oder des Austauschs leicht von der Verdampferzelle entfernt werden, ohne dass eine aufwendige Demontage erforderlich ist. Hierzu weist das Thermoelement vorzugsweise eine gerade Bauform auf. Dies ermöglicht, dass das Thermoelement durch einen geraden Kanal durch die Halteeinrichtung des Tiegels und ggf. weitere Komponenten der Verdampferzelle bis zur gewünschten Position unterhalb des Tiegelbodens vorgeschoben werden kann. Der optimale axiale Abstand vom Tiegelboden kann zum Beispiel durch Testreihen oder durch eine vorherige Kalibrierungsmessung ermittelt werden.

Gemäß einer weiteren vorteilhaften Merkmal der Erfindung ist die Halteeinrichtung der Verdampferzelle zur thermisch isolierten Positionierung des Tiegels relativ zu den anderen Teilen der Verdampferzelle und insbesondere relativ zu einem Träger eingerichtet. Die Halteeinrichtung stellt eine mechanische Halterung dar, welche die äußere Oberfläche des Tiegels im Wesentlichen freilässt, wenn dieser aus einem elektrisch leitfähigen Material gebildet ist. Vorzugsweise ist die Halteeinrichtung in diesem Fall am Tiegelboden vorgesehen, so dass die Seitenwände des Tiegels für die Wärmeübertragung von der Heizeinrichtung freiliegen. Wenn die Halteeinrichtung aus einem elektrisch leitfähigen Material besteht, kann sie vorteilhafterweise neben der mechanischen Halterung gleichzeitig als Hochspannungskontakt für den Tiegel dienen. Wenn der Tiegel aus einem elektrisch nicht leitfähigen Material besteht, ist die Halteeinrichtung so geformt, dass sie den größten Teil der Außenfläche des Tiegels überdeckt. In diesem Fall ist vorzugsweise eine formschlüssige Verbindung zwischen der Außenfläche des Tiegels und der Innenseite der Halteeinrichtung vorgesehen.

Wenn die Halteeinrichtung durch ein Bauteil mit einem Hohlprofil gebildet wird, können sich Vorteile für die Verminderung der Wärmeleitung vom Tiegel zur Umgebung und für eine stabile Positionierung des Tiegels auch bei extrem hohen Temperaturen ergeben. Die Halteeinrichtung ist bspw. ein Hohlzylinder oder ein Hohlkonus, der an der Unterseite des Tiegels angebracht ist. Die zylinder- oder konusförmige Halteeinrichtung weist eine besonders hohe mechanische Stabilität auf. Der Tiegel wird steif und vollflächig mit einem Schutz gegen Torsion und Verbiegung gehalten.

Vorteilhafterweise wird durch das Hohlprofil, das den Hochspannungskontakt des Tiegels bildet, in unmittelbarer Umgebung des Tiegels ein Raum geschaffen, in dem die Betriebstemperatur des Tiegels messbar ist und in dem eine reduzierte Feldstärke gegeben ist. Daher ist die Temperaturmesseinrichtung vorzugsweise zur Temperaturmessung im Inneren der Halteeinrichtung vorgesehen. Die Halteeinrichtung weist zum Beispiel eine axiale Öffnung auf, durch welche das Thermoelement in die Halteeinrichtung einführbar ist. Die Positionierung des Thermoelements im Hohlprofil der Halteeinrichtung hat den besonderen Vorteil, dass eine allseitige Abschirmung des Thermoelements insbesondere gegen die hohen Feldstärken beim Betrieb der Heizeinrichtung als Elektronenstrahlheizung erreicht wird und unerwünschte Hochspannungsüberschläge vermieden werden.

Vorzugsweise ist an dem Träger eine Aufnahme vorgesehen, in welche die Halteeinrichtung einsteckbar ist. Die Aufnahme besitzt bspw. die Form eines zylinder- oder konusförmigen Schachtes, dessen Innenform an die Außenform des Hohlprofils der Halteeinrichtung angepasst ist. Vorteilhafterweise bildet die eingesteckte Halteeinrichtung einen festen mechanischen Kontakt mit dem Träger, so dass ein Verkippen des Tiegels während des Betriebes der Verdampferzelle vermieden wird.

Vorteilhafterweise ermöglicht die erfindungsgemäße Verdampferzelle eine genaue Temperatureinstellung im Tiegel. Hierzu ist vorzugsweise eine Regeleinrichtung vorgesehen, mit der die Heizeinrichtung einstellbar ist. Die Regeleinrichtung kann die folgenden Regelkreise enthalten. Ein erster Regelkreis dient der Einstellung eines Heizstroms des Heizwiderstandes für einen Widerstandsheizbetrieb. Der zweite Regelkreis dient der Einstellung eines Elektronenstroms vom Heizwiderstand zum Tiegel für einen Elektronenstrahl-Heizbetrieb.

In den Regelkreisen wird der Heiz- und/oder Elektronenstrom des Heizwiderstandes allgemein unter Verwendung einer Istgröße geregelt, die in Abhängigkeit von der konkreten Aufgabe der Verdampferzelle gewählt ist. Beispielsweise kann eine gemessene Aufdampfrate als Istgröße für die Regelkreise verwendet werden. Bevorzugt erfolgt die Regelung in Abhängigkeit von der Betriebstemperatur des Tiegels. Hierzu ist die Temperaturmesseinrichtung mit wenigstens einem der Regelkreise verbunden.

Weitere Vorteile werden mit einer Ausführungsform der Erfindung erzielt, bei der die Regeleinrichtung einen einzigen Regelkreis aufweist, mit dem die Temperatur der Verdampferzelle einstellbar ist. Besonders bevorzugt ist der einzige Regelkreis für eine Spannungsregelung der Heizeinrichtung vorgesehen. Mit dem Regelkreis wird in Abhängigkeit von einer IstGröße, z. B. der Temperatur, die mit der Temperaturmesseinrichtung ermittelt wurde, die Spannung an den Enden der parallel geschalteten Heizelemente eingestellt. Vorteilhafterweise wird die Verdampferzelle ausschließlich über die Heizspannung der Parallelschaltung der Heizelemente geregelt.

Die Erfinder haben festgestellt, dass durch die Parallelschaltung der Heizelemente erreicht wird, dass bei einer ausreichend hohen Heizspannung, vorzugsweise im Bereich von 2 V bis 8 V, z. B. bei 4 V automatisch der Übergang von der Widerstandsheizung zur Elektronenstrahlheizung erfolgt, wobei die Leistung der Elektronenstrahlheizung passiv und mit hoher Stabilität dem Verlauf der Heizspannung folgt. Im Unterschied zur Regelung der herkömmlichen Verdampferzelle ist es nicht erforderlich, die Hochspannungsquelle zu regeln. Es wurde festgestellt, dass die Hochspannungsquelle bei Regelung der Heizspannung der Heizelemente selbst nachführend arbeitet. Überraschenderweise wurde mit dem einen Regelkreis selbst bei gleichzeitigem Widerstands- und Elektronenstrahlheizbetrieb keine oszillierende, sondern eine stabile Regelcharakteristik beobachtet.

Die bevorzugte Regelcharakteristik der Elektronenstrahlheizung zeichnet sich durch eine Temperatur-Emissionsregelung aus, bei der mit steigender Temperatur der Heizbereiche der Widerstand der Vakuumstrecke zum Tiegel stetig sinkt. Der Elektronenstrom über die Vakuumstrecke steigt mit steigender Temperatur der Heizbereiche kontinuierlich an. Hierzu im Gegensatz wäre mit einer Feld-Emissionsregelung ein sprunghafter Anstieg des Elektronenstroms gegeben. Die Temperatur-Emissionsregelung wird mit einer Beschleunigungsspannung, für die bei der gegebenen Länge der Vakuumstrecke eine FeldEmission ausgeschlossen ist (z. B. U < 500 V), und einem ausreichend hohen Elektronenstrom, bei dem die Temperatur-Emission erfolgt (z. B. I = 1 A bis 3 A), der Elektronenstrahlheizung erzielt.

Als besonders vorteilhaft hat es sich erwiesen, wenn der Tiegel und der Heizwiderstand der erfindungsgemäßen Verdampferzelle, und vorzugsweise auch die Abschirmwand der Abschirmeinrichtung vollständig aus Tantal bestehen. Obwohl Tantaloxid einen relativ niedrigen Schmelzpunkt und einen relativ hohen Dampfdruck hat, konnten die Erfinder überraschenderweise feststellen, dass selbst im Hochtemperaturbetrieb der Verdampferzelle keinerlei unerwünschtes Tantal in Schichten gefunden wurde, die mit der Verdampferzelle hergestellt wurden.

Eine Beschichtungsanlage, die mit mindestens einer erfindungsgemäßen Verdampferzelle ausgestattet ist, stellt einen unabhängigen Gegenstand der Erfindung dar. Im Gegensatz zu herkömmlichen Elektronenstrahlverdampfern, bei denen typischerweise flache Tiegel vorgesehen sind, kann die Verdampferzelle in der Beschichtungsanlage mit einem relativ zur Vertikalen schräg oder sogar horizontal ausgerichteten Tiegel angeordnet sein.

Weitere Einzelheiten und Vorteile der Erfindung werden im Folgenden unter Bezugnahme auf die beigefügten Zeichnungen erläutert. Es zeigen:
- Figuren 1A und 1B:: schematische Ansichten der ersten zweiten Ausführungsform der erfindungsgemäßen Verdampfer- zelle;
- Figuren 2A und 2B:: schematische Ansichten der zweiten Aus- führungsform der erfindungsgemäßen Verdampferzel- le;
- Figuren 3A und 3B:: schematische Ansichten weiterer Varianten der zweiten Ausführungsform der erfindungsgemäßen Verdampferzelle;
- Figur 4:: die erfindungsgemäße Kombination der Verdampfer- zelle mit einer Regeleinrichtung;
- Figur 5:: eine Kurvendarstellungen zur Illustration ver- schiedener Betriebszustände der erfindungsgemäßen Verdampferzelle; und
- Figuren 6A bis 6C:: Einzelheiten einer weiteren Ausführungs- form einer erfindungsgemäßen Verdampferzelle.

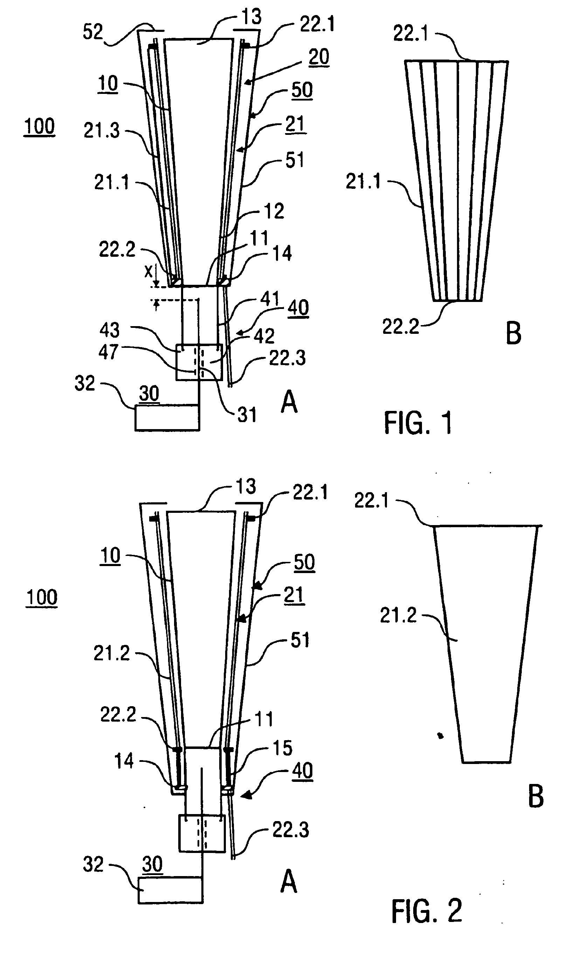

Die in Figur 1A in schematischer Schnittansicht gezeigte erste Ausführungsform der erfindungsgemäßen Verdampferzelle 100 umfasst einen Tiegel 10, einen Heizwiderstand 21 einer Heizeinrichtung 20, eine Temperaturmesseinrichtung 30, eine Halteeinrichtung 40 und eine Abschirmeinrichtung 50. Der Heizwiderstand 21 umfasst parallel geschaltete Heizbereiche, die durch getrennt verlaufende Heizelemente 21.1 gebildet werden.

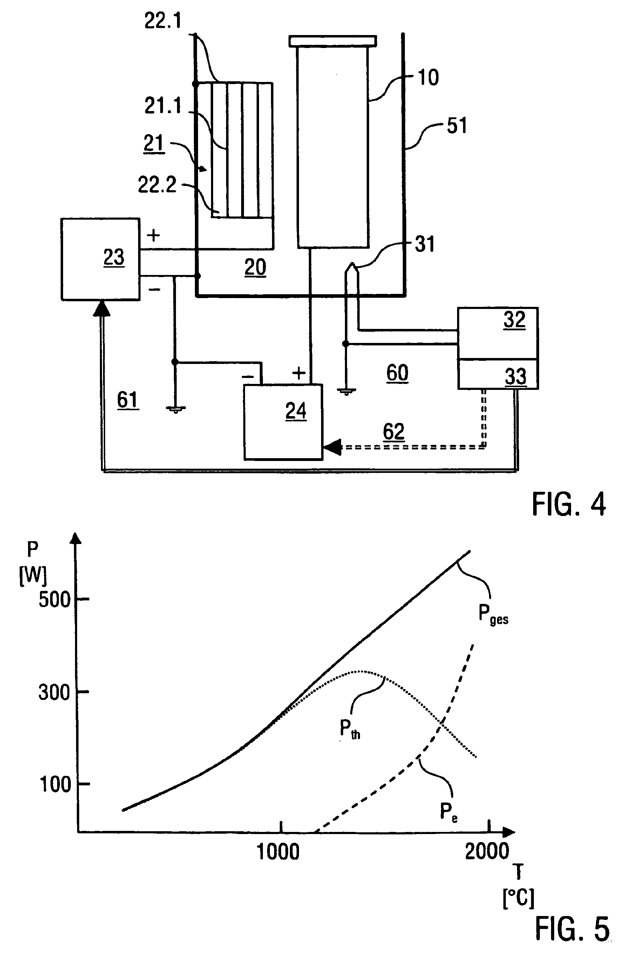

Der Tiegel 10 zur Aufnahme von Verdampfungsgut mit einem Tiegelboden 11, einer umlaufenden Seitenwand 12 und einer Austrittsöffnung 13 weist eine Konusform mit einem sich vom Tiegelboden 11 zur Austrittsöffnung 13 vergrößernden Durchmesser auf. Der Tiegel 10 besteht aus einem ein- oder mehrlagigen Material, das bis zu einer Temperatur von 3000 °C formbeständig und mechanisch stabil ist. Der Tiegel 10 kann vollständig aus einem Metallblech oder aus einer Zusammensetzung mit einem nicht-elektrisch leitfähigen Grundkörper und einer metallischen Beschichtung bestehen, wobei zum Verdampferbetrieb der elektrisch leitfähige Teil des Tiegels 10 jeweils mit einer Hochspannungsquelle 24 (siehe Figur 4) verbunden ist. Der Tiegel 10 besteht bspw. komplett aus Tantal oder aus einer Tantal-Wolfram-Kombination oder einer Wolfram-Rhenium-Legierung. Die Wolfram-Tantal-Kombination umfasst bspw. einen Aufbau mit dem Tiegelboden 11 aus Wolfram und der Seitenwand 12 aus Tantal oder einen zweilagigen Aufbau mit einem inneren Wolfram-Konus und einem äußeren Tantal-Konus. Die letztere Variante hat den Vorteil, dass das äußere Tantalblech den inneren Wolframkonus mechanisch stabilisiert. Die Maße des Tiegels 10 betragen für ein Innenvolumen von rd. 10 cm³ z. B.: Durchmesser des Tiegelbodens: 1 cm, axiale Länge des Tiegels 10: rd. 10 bis 15 cm, Durchmesser der Austrittsöffnung 13: rd. 1.5 cm.

Die Temperaturmesseinrichtung 30 umfasst ein Thermoelement 31, dessen Kontaktstelle unterhalb des Tiegelbodens 11 angeordnet und mit einem Messwandler 32 verbunden ist. Das Thermoelement ist bspw. ein Wolfram-Rhenium-Thermoelement, wie es in der o. g. Publikation von R. R. Asamoto et al. beschrieben ist. Der Messwandler 32 ist bspw. vom Typ "Eurotherm 2604".

Die Halteeinrichtung 40 umfasst einen Hohlzylinder 41 aus einem temperaturbeständigen Material, z. B. Tantal mit einem axial verlaufenden Kanal 47. Durch den Kanal 47 kann das Thermoelement 31 elektrisch isoliert durch das Innere des Hohlzylinders 41 eingeführt werden. Das Thermoelement 31 ist im Kanal 44 verschiebbar, so dass der axiale Abstand X vom Tiegelboden einstellbar ist. Der axiale Abstand X wird z. B. im Bereich von 2 mm bis 15 mm eingestellt.

Der untere Rand des Hohlzylinders 41 ist mit einem Träger 42 verbunden, der ortsfest oder verstellbar in einer Beschichtungsanlage angeordnet ist. Der Träger 42 enthält eine ringförmige Aufnahme 43, in welcher der untere Rand des Hohlzylinders 41 befestigt ist. Die Halteeinrichtung 40 dient der stabilen Halterung und als elektrischer Hochspannungskontakt des Tiegels 10.

Die Halteeinrichtung 40 stellt eine thermische Isolation zwischen dem Tiegel 10 und den übrigen Teilen an der Beschichtungsanlage dar. Zur Minimierung der Wärmeleitung besteht der Hohlzylinder 41 aus einem Blech mit einer Dicke unterhalb von 500 µm, vorzugsweise kleiner als 200 µm, z. B. im Bereich von 50 µm bis 200 µm.

Die Abschirmeinrichtung 50 umfasst eine seitlich umlaufende Abschirmwand 51 und eine Abschirmkappe 52. Die Abschirmwand 51 stellt eine thermische Barriere nach außen und eine mechanische Halterung für den oberen Ringleiter 22.1 der Heizeinrichtung 20 dar. Sie besteht z. B. aus Ta-Blech mit einer Dicke von 50 µm oder mehreren Lagen einer Ta-Folie. Die Abschirmkappe 52 dient der thermischen Isolation zwischen der Verdampferzelle 100 und einem zu beschichtenden Substrat. Mit der Abschirmkappe 52 wird der Spalt zwischen dem Tiegel 10 und der Abschirmwand 51, in dem die Heizelemente 21.1 angeordnet sind, hin zum Substrat abgeschirmt. In der Mitte der Abschirmkappe 52 ist eine Öffnung vorgesehen, die den Dampfstrahl aus dem Tiegel 10 zum Substrat durchlässt. Die Öffnung wird je nach Anwendung möglichst klein gewählt (z. B. 15 mm), um die Homogenität der Temperaturverteilung im Tiegel 10 zu verbessern und die erforderliche Heizleistung zu minimieren.

Die Heizelemente 21.1 der Heizeinrichtung 20, die den Heizwiderstand 21 bilden, sind getrennte Heizleiter, die sich zwischen einem oberen Ringleiter 22.1 und einem unteren Ringleiter 22.2 erstrecken (siehe schematische Seitenansicht in Figur 1B). Des Weiteren ist eine Anschlussleitung 22.3 vorgesehen, die mit der Heizstromquelle 23 (siehe Figur 4) verbunden ist. Die Heizelemente 21.1 erstrecken sich freitragend zwischen den oberen und unteren Ringleitern 22.1, 22.2. Jedes der Heizelemente 21.1 besteht aus einem geraden Widerstandsdraht, der aus einem für Widerstandsheizungen an sich gebräuchlichen Material, wie z. B. Wolfram oder Tantal mit einem Durchmesser von z. B. 0.635 mm hergestellt ist. Die Anzahl der Heizelemente 21.1 ist beispielsweise im Bereich von 4 bis 20, besonders bevorzugt im Bereich von 6 bis 10 gewählt. Die Heizelemente 21.1 sind azimutal gleichmäßig auf dem Umfang um den Tiegel 10 verteilt angeordnet.

Gemäß einer abgewandelten Variante der Erfindung können die Heizelemente durch gekrümmte Widerstandsdrähte gebildet werden. Alle Widerstandsdrähte weisen in diesem Fall die gleiche Krümmung auf, so dass die Heizelemente mit gegenseitigen Abständen zwischen den oberen und unteren Ringleitern 22.1, 22.2 parallel angeschlossen werden können. Gekrümmte Heizelemente können zum Beispiel eine periodische Struktur, wie zum Beispiel eine Wellen-, Dreieck- oder Spiral-Struktur oder eine zwischen den oberen und unteren Ringleitern 22.1, 22.2 sich erstreckende Bogenstruktur aufweisen.

Die Heizelemente 21.1 sind auf der Außenseite der Seitenwand 12 mit einem radialen Abstand von deren Oberfläche angeordnet. Der radiale Abstand wird durch die Dimensionen der oberen und unteren Ringleiter 22.1, 22.2 und deren Befestigung einerseits an der Abschirmeinrichtung 50 und andererseits am Tiegel 10 bestimmt.

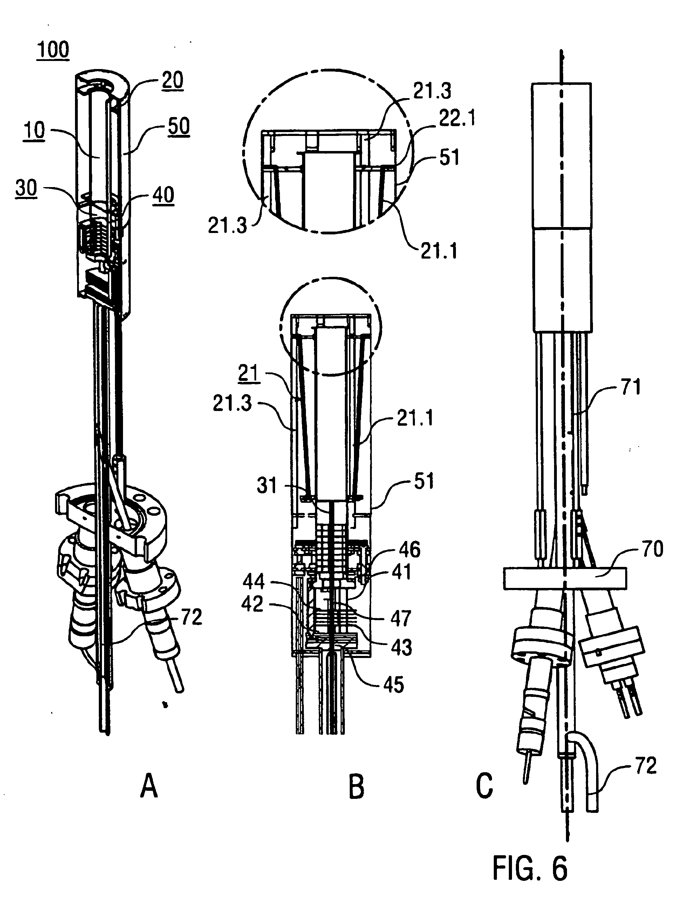

Der obere Ringleiter 22.1 ist über radial außerhalb der Heizelemente 21.1 und innerhalb der Abschirmeinrichtung 50 verlaufende Stäbe (siehe z. B. 21.3) am Isolator 14, am Träger 42 oder einem anderen ortsfesten Teil der Beschichtungsanlage befestigt (siehe auch Figur 6). Es sind mehrere Stäbe 21.3 (z. B. drei) vorgesehen, die azimutal gleichmäßig verteilt angeordnet sind. Die Stäbe 21.3 bestehen zum Beispiel aus Tantal mit einem Querschnitt von 2 bis 3 mm. Es kann eine Berührung oder ein elektrischer Kontakt der Stäbe 21.3 mit der inneren Oberfläche der Abschirmwand 51 vorgesehen sein, die zum Beispiel durch Tantal gebildet wird.

Die Abschirmeinrichtung 50 ist an einem elektrisch isolierenden Teil des Trägers 42 oder einem anderen ortsfesten Teil einer Beschichtungsanlage (nicht dargestellt) befestigt. Die Abschirmwand 51 kann auf den Stäben 21.3 aufsitzen, die einen Rahmen oder ein Gerüst für die Abschirmeinrichtung 50 bilden. Die Abschirmeinrichtung 50 kann zusätzlich einen äußeren Kühlschild (nicht dargestellt) aufweisen, der z. B. einen mit flüssigem Stickstoff oder Wasser gekühlten Doppelmantel umfasst. Da der obere Ringleiter 22.1 einen Abstand von der Seitenwand 12 und der Tiegelöffnung 13 aufweist, ist der Tiegel 10 frei stehend ausschließlich auf der Halteeinrichtung 40 befestigt. Der obere Ringleiter 22.1 besteht zum Beispiel aus einem gebogenen Draht (Torus) aus Tantal mit einem Durchmesser von 2 mm oder einem ringförmigen Tantalblech mit einer Dicke von 1 mm.

Der untere Ringleiter 22.2 ist auf einem ringförmigen Isolator 14 befestigt, der den Tiegel 10 am Tiegelboden 11 umgibt. Der Isolator 14 ist an der Seitenwand 12 oder einem abgewinkelten Teilbereich der Abschirmwand 51 befestigt. Die Befestigung wird zum Beispiel durch Bornitrid gebildet. Der Isolator 14 enthält eine Durchgangsöffnung zur Aufnahme der Anschlussleitung 22.3, die mit dem unteren Ringleiter 22.2 verbunden ist. Der untere Ringleiter 22.2 besteht ebenfalls aus Tantal in Form eines gebogenen Drahtes (Torus) oder ringförmigen Bleches. Die Heizelemente 21.1 sind mittels einer Schweißverbindung am unteren Ringleiter 22.2 befestigt. Der Isolator 14 besteht z. B. aus Bornitrid, Saphir oder Quartz.

Die in Figur 2A in schematischer Schnittansicht gezeigte zweite Ausführungsform der erfindungsgemäßen Verdampferzelle 100 umfasst ebenfalls den Tiegel 10, den Heizwiderstand 21 der Heizeinrichtung 20, die Temperaturmesseinrichtung 30, die Halteeinrichtung 40 und die Abschirmeinrichtung 50. Diese Komponenten sind im Wesentlichen so aufgebaut, wie dies oben unter Bezug auf die Figur 1A beschrieben ist. Ein wesentlicher Unterschied gegenüber der ersten Ausführungsform besteht in Bezug auf die Verbindung der Heizbereiche zu einer Widerstandshülse 21.2.

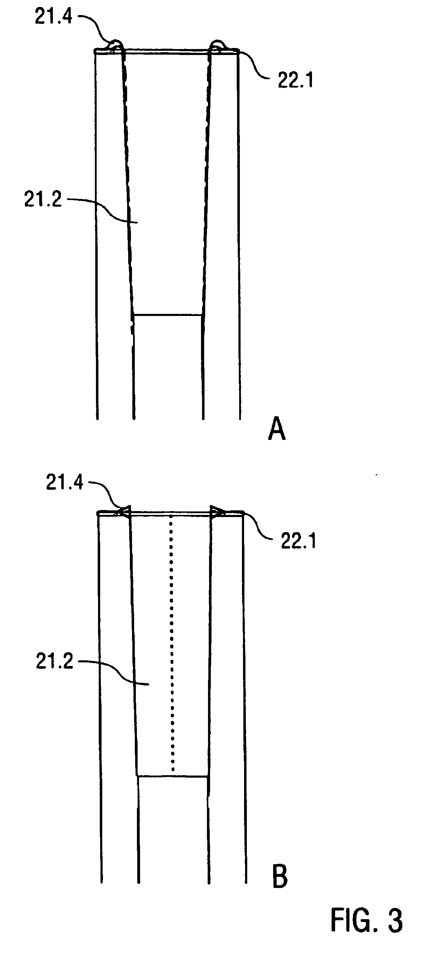

Wie mit der schematischen Seitenansicht in Figur 2B illustriert bilden die Heizbereiche eine konusförmige Widerstandshülse 21.2, deren Durchmesser sich vom Tiegelboden 11 zur Tiegelöffnung 13 vergrößert. Die Widerstandshülse 21.2 ist zum Beispiel aus einer Tantalfolie mit einer Dicke kleiner oder gleich 30 µm, z. B. 25 µm oder 10 µm hergestellt. Der Durchmesser am unteren Rand der Widerstandshülse 21.2 ist beispielsweise im Bereich von 1 cm bis 2 cm gewählt, während der Durchmesser am oberen Rand der Widerstandshülse 21.2 zwischen 2 cm und 3 cm gewählt ist. Die Widerstandshülse 21.2 ist bei der in Figur 2 gezeigten Variante mit ihrem oberen Rand oder mit einem optional am oberen Rand vorgesehenen oberen Ringleiter wie bei der ersten Ausführungsform an Stäben befestigt (in Figur 2 nicht dargestellt). Abgewandelte Varianten der Befestigung der Widerstandshülse 21.2 sind unten unter Bezug auf Figur 3 beschrieben. Der untere Rand der Widerstandshülse 21.2 ist mit einem angeschweißten Ring 22.2 versehen und über Haltestifte 15 und einen ringförmigen Isolator 14 an der Halteeinrichtung 40 mit einem axialen Abstand unterhalb des Tiegelbodens 11 befestigt.

Die Haltestifte 15, die die Widerstandshülse 21.2 tragen, sind auf dem ringförmigen Isolator 14 befestigt. Es sind beispielsweise zwei oder mehr Haltestifte 15 vorgesehen, die aus einem elektrisch isolierenden Material, z. B. Bornitrid (insbesondere pyrolytisch abgeschiedenes Bornitrid, PBN, oder aus einem elektrisch leitfähigen Material, z. B. Tantal oder Wolfram bestehen. Einer der Haltestifte 15 kann als elektrische Verbindung der konusförmigen Hülse 21.2 mit der Anschlussleitung 22.3 verwendet werden.

Die in Figur 2A gezeigte Kombination des Isolators 14 mit den Haltestiften 15 kann auch bei der Halterung des Heizwiderstandes bei der ersten Ausführungsform der Erfindung (siehe Figur 1A) vorgesehen sein.
Figur 3 zeigt weitere Varianten der Widerstandshülse 21.2, die vorteilhafterweise eine verbesserte Stabilität der Befestigung des oberen Randes der Widerstandshülse 21.2 ermöglichen. Aus Gründen der Übersichtlichkeit sind in Figur 3 der Tiegel und weitere Teile der Verdampferzelle nicht gezeigt.
Die Widerstandshülse 21.2 weist an ihrem oberen Ende in der Umgebung der Tiegelöffnung 13 mehrere Einschnitte auf, durch die in Umfangsrichtung der Widerstandshülse 21.2 biegsame Streifen 21.4 gebildet werden. Die Streifen 21.4 bestehen aus dem Wandmaterial der Widerstandshülse 21.2. Es sind z. B. am oberen Ende der Widerstandshülse 21.2 in Umfangsrichtung 10 bis 20 gleichmäßig verteilte Streifen 21.4 vorgesehen, die in axialer Richtung eine Länge von z. B. 1 cm (Länge der Einschnitte) aufweisen. Die Streifen 21.4 sind in radialer Richtung nach außen geführt, z. B. umgebogen oder geknickt, und am oberen Ringleiter befestigt, z. B. mit dem oberen Ringleiter 22.1 verschweißt.

Vorteilhafterweise verbessert die Befestigung des oberen Randes der Widerstandshülse 21.2 über die Streifen 21.4 den Ausgleich thermischer Änderungen der Länge der Widerstandshülse 21.2. Wenn sich die Länge der Widerstandshülse 21.2 im heißen Zustand z. B. um bis zu zwei Millimeter gegenüber dem kalten Zustand vergrößert, kann diese Längenänderung durch die Streifen 21.4 aufgenommen werden. Somit kann eine unerwünschte thermisch-mechanische Überbeanspruchung der Widerstandshülse 21.2, wie z. B. eine Stauchung oder Verformung, oder sogar deren Abriss vom Ringleiter sicher vermieden werden. Der Ringleiter kann einen im Vergleich zu Figur 2 größeren Durchmesser aufweisen.

Gemäß Figur 3A wird die Widerstandshülse 21.2 an ihrem oberen Ende nicht vollflächig, sondern über die bogenförmigen Streifen 21.4 mit dem oberen Ringleiter verschweißt. Dadurch kann sich die Widerstandshülse 21.2 in axialer Länge ausdehnen, ohne mechanisch überbeansprucht zu werden. Somit kann eine mechanische Zerstörung der Widerstandshülse durch unterschiedliche thermische Ausdehnung im Verhältnis zum kälteren äußeren Teil der Zelle wirksam verhindert werden.

Gemäß Figur 3B werden die Streifen 21.4 nicht bogenförmig geführt, sondern mit engem Radius abgeknickt und nahezu senkrecht zur Tiegelmittelachse radial nach außen geführt. Im kalten Zustand ist der Winkel von Boden her betrachtet größer als 90 Grad, im heißen Zustand kleiner als 90 Grad, vorzugsweise um jeweils denselben Betrag. In Figur 3B sind beide Zustände illustriert. Durch die nahezu senkrechte radiale Abspannung des oberen Hülsenrandes ergibt sich eine stabile seitliche Führung des oberen Endes der Widerstandshülse 21.2, ohne die Möglichkeit der leichten thermischen Ausdehnungsmöglichkeit der Widerstandshülse 21.2 zu verlieren. Vorteilhafterweise wird damit eine seitliche Abweichung der Widerstandshülse 21.2 aus der Symmetrieachse der Zelle und ein Kurzschluss mit dem Tiegel in der Mitte (in Figur 3 nicht dargestellt) sicher vermieden.

Gemäß einer weiteren Ausführungsform der Erfindung kann die Widerstandshülse 21.2 an ihrem unteren Ende, d. h. in der Umgebung des Tiegelbodens Einschnitte aufweisen, durch die in Umfangsrichtung der Widerstandshülse 21.2 biegsame Streifen gebildet werden, wie dies oben unter Bezug auf die Figuren 3A und 3B beschrieben ist. Die Streifen sind dann am unteren Ringleiter 22.2 (siehe Figur 2) befestigt. Des Weiteren kann die Befestigung über gekrümmte oder geknickte Streifen an beiden axialen Enden der Widerstandshülse 21.2 (Heizfolie) vorgesehen sein.

Figur 4 illustriert schematisch die Verbindung der Heizeinrichtung 20 mit der Heizstromquelle 23 und der Hochspannungsquelle 24. Aus Übersichtlichkeitsgründen sind in Figur 3 die oberen und unteren Ringleiter 22.1, 22.2 und die Heizelemente 21.1 neben dem Tiegel 10 gezeigt, obwohl sie in der Praxis den Tiegel 10 umgeben. Mit der zweiten Ausführungsform sind die Heizelemente 21.1 durch die Widerstandshülse 21.2 ersetzt.

Die Einstellung des Betriebsstroms der Heizeinrichtung 20 erfolgt mit einer schematisch in Figur 4 gezeigten Regeleinrichtung 60. Die Heizelemente 21.1 auf der Außenseite des Tiegels 10 sind parallel geschaltet an die Heizstromquelle 23 angeschlossen. Die Heizstromquelle 23 ist ein regelbares Gleichstrom-Netzteil für einen Heizstrom bis zu 120 A bei einer Ausgangs-Gleichspannung bis 20 V. Der eine (positive) Anschlusskontakt der Heizstromquelle 23 ist mit dem unteren Ringleiter 22.2 verbunden, während der andere (negative) Anschlusskontakt der Heizstromquelle 23 gemeinsam mit dem oberen Ringleiter 22.1, der Abschirmwand 51, dem negativen Anschlusskontakt der Hochspannungsquelle 24 und einem Anschluss des Thermoelements 31 mit Massepotential verbunden ist. Die Erdung des Thermoelements 31 ist optional vorgesehen. Alternativ können der Messwandler 32 und der Regler 33 auf Tiegelpotential liegen.

Die Hochspannungsquelle 24 ist ein Gleichspannungs-Netzteil mit einem Ausgangsstrom z. B. bis zu 10 A und einer Ausgangsspannung z. B. bis zu 500 V. Aus Kostengründen und wegen des vereinfachten Betriebs im Niederspannungsbereich wird vorzugsweise eine Hochspannungsquelle 24 mit einer Ausgangsspannung von kleiner oder gleich 300 V verwendet. Der positive Anschlusskontakt der Hochspannungsquelle 24 ist über die Halteeinrichtung 40 (siehe Figuren 1 oder 2) mit dem Tiegel 10 verbunden, der beim Elektronenstrahlbetrieb der Heizeinrichtung 20 die Anode repräsentiert, auf die Elektronen von den Heizelementen 21.1 beschleunigt werden. Gemäß abgewandelten Varianten der Erfindung kann die Hochspannungsquelle für niedrigere (zum Beispiel bis zu rd. 50 V) oder höhere Spannungen (zum Beispiel bis zu rd. 5000 V) ausgelegt sein. In der Praxis werden geringere Spannungen bei entsprechend möglichst hohen Strömen bevorzugt, um unbeabsichtigte elektrische Überschläge zu vermeiden und um eine weiche Regelcharakteristik der Elektronenstrahlheizung (Temperatur-Emissionsregelung) zu erhalten.

Der Messwandler 32 des Thermoelements 31 ist mit einem Regler 33 (zum Beispiel einem PID-Regler) verbunden. In Abhängigkeit von der Gestaltung der Regeleinrichtung 60 weist der Regler 33 einen oder zwei Ausgänge auf, von denen Stellsignale an die Heizstromquelle 23 und optional an die Hochspannungsquelle 24 geliefert werden.

Vorzugsweise umfasst die Regeleinrichtung 60 einen einzigen Regelkreis 61. Im Regelkreis 61 wird die Ausgangsspannung der Heizstromquelle 23, mit der die oberen und unteren Ringleiter 22.1, 22.2 beaufschlagt werden, in Abhängigkeit von der Betriebstemperatur des Tiegels 10 geregelt. Alternativ können wie bei der herkömmlichen Verdampferzelle zwei Regelkreise 61, 62 vorgesehen sein (siehe gestrichelter Pfeil von 33 nach 24). Im optional vorgesehenen Regelkreis 62 wird der Elektronenstrom von den Heizelementen 21.1 zum Tiegel 10 ebenfalls in Abhängigkeit von der Betriebstemperatur des Tiegels 10 geregelt.

Bei der Temperatureinstellung wird bspw. die in Figur 5 gezeigte Kennlinie realisiert. In einer ersten Betriebsphase erfolgt zunächst eine Beaufschlagung der Heizelemente 21.1 mit einer Heizspannung, so dass durch die Heizelemente 21.1 ein Heizstrom fließt. Die Heizleistung Pₜₕ und damit die Temperatur des Tiegels 10 wird ausschließlich über die Heizspannung geregelt. Mit der Regeleinrichtung 33 wird gemäß Figur 5 die Temperatur im Tiegel zunächst mit der thermischen Heizung (gepunktet, Leistung Pₜₕ) erhöht, bis eine Temperatur erreicht ist, bei der die Elektronenemission vom Heizwiderstand 21 einsetzt. Wenn durch die Widerstandsheizung eine ausreichend hohe Temperatur von z. B. 1000°C bis 1500°C erreicht wurde, setzt in einer weiteren Betriebsphase die Elektronenstrahlheizung ein. Die Elektronenemission von den Heizelementen 21.1 zum Tiegel 10 setzt bspw. bereits bei einer Hochspannung von 300 V ein. Die Heizung wird durch die Elektronenstrahl-Heizung (gestrichelt, Leistung Pₑ) überlagert. Beide Anteile addieren sich zur Leistung P_{ges} (durchgezogen gezeichnet). Zur weiteren Temperaturerhöhung wird die Leistung Pₜₕ der Widerstandsheizung nicht erhöht, sondern die Elektronenstrahlheizung verwendet. Die Widerstandsheizung wird vermindert. Erfindungsgemäß kann die Widerstandsheizung bei einer Tiegeltemperatur oberhalb von 2200 °C sogar abgeschaltet werden, da die Heizelemente durch den Tiegel geheizt werden. Mit einer Steigerung des Elektronenstroms auf z. B. 1 A bei einer Spannung von 2000 V über die Vakuumstrecke zwischen den Heizelementen und dem Tiegel wird eine Temperatur von 2700°C erreicht.

Um einen möglichst fließenden Übergang der Temperatureinstellung beim Wechsel von der Widerstands- zur Elektronenstrahlheizung zu erreichen, wird die Hochspannung der Hochspannungsquelle 24 bereits während der ersten Betriebsphase der Widerstandsheizung an den Tiegel 10 angelegt.

Einzelheiten einer weiteren Ausführungsform der Verdampferzelle 100 sind in den Figuren 6A (perspektivische Schnittansicht), 6B (vergrößerte Teilansicht) und 6C (Seitenansicht) dargestellt. Der wesentliche Unterschied zwischen den Ausführungsformen der Figur 1 (oder 2) und 6 besteht in der geometrischen Form des Tiegels 10. Im Übrigen können die in Figur 6 gezeigten Einzelheiten auch bei den in den Figuren 1, 2 oder 3 gezeigten Ausführungsformen der Erfindung realisiert sein.

Die Figuren 6A und 6B zeigen Einzelheiten des Tiegels 10, des Heizwiderstandes 21, der Temperaturmesseinrichtung 30, der Halteeinrichtung 40 und der Abschirmeinrichtung 50. Der Tiegel 10 ist ein gerader Hohlzylinder aus Wolframblech. Die Abschirmwand 51 besteht aus mehreren Lagen einer Tantalfolie. Die Heizelemente 21.1 des Heizwiderstandes 21 erstrecken sich über die gesamte Länge des Tiegels 10. Vorteilhafterweise erfolgt bei der Elektronenstrahlheizung die Elektronenemission ebenfalls entlang der gesamten Länge der Heizelemente 21.1.

In den Figuren 6A und 6B ist beispielhaft eine Konusform des Heizwiderstandes 21 gezeigt, deren Durchmesser sich in Axialrichtung zur Tiegelöffnung vergrößert. Alternativ kann der Heizwiderstand 21 eine Zylinderform mit einem konstanten radialen Abstand der Heizelemente 21.1 von dem zylinderförmigen Tiegel 10 oder eine Konusform aufweisen, deren Durchmesser sich in Axialrichtung zur Tiegelöffnung verringert.

Die mechanische Halterung der Heizelemente 21.1 und des oberen Ringleiters 22.1 erfolgt mit den Stäben 21.3, die auf der Innenseite der Abschirmwand 51 angeordnet sind.

Der Hohlzylinder 41 der Halteeinrichtung 40 verjüngt sich an seinem unteren Ende konusförmig. Die konusförmige Verjüngung steckt in einer ebenfalls konusförmigen Aufnahme 43 des Trägers 42. Die Fixierung des Hohlzylinders 41 in der Halterung 43 erfolgt mit einem ebenfalls konusförmigen Innenstück 44, das mit einer Spannschraube 45 in die Aufnahme 43 des Trägers 42 gezogen werden kann. Die Spannschraube 45 ist innen hohl, so dass der Kanal 47 gebildet wird, um das Thermoelement 31 axial in den Innenraum des Hohlzylinders 41 durchzuführen. Auf der Oberseite des Trägers 42 sind mehrere Lagen eines Tantalbleches 46 angeordnet, um die thermische Isolation zwischen dem Tiegel 10 und dem Träger 42 zu verbessern.

Der Träger 42 ist mit einem Sockel 70 über starre Rohrleitungen 71 verbunden, in denen die Anschlussleitungen des Heizwiderstandes, die Hochspannungsleitung des Tiegels und die Leitungen des Thermoelements angeordnet sind. Die Rohrleitungen 71 dienen des Weiteren einer Kühlung der Anschlussleitungen und der Halteeinrichtung 40 mit Kühlwasser, das über Kühlwasseranschlüsse 72 (siehe Figur 6C) zugeführt wird. Der Sockel 70 weist einen Vakuumflansch (z. B. mit der Größe CF 40) auf, der an einer Beschichtungsanlage montierbar ist.

Die in der vorstehenden Beschreibung, den Zeichnungen und den Ansprüchen offenbarten Merkmale der Erfindung können sowohl einzeln als auch in Kombination für die Verwirklichung der Erfindung in ihren verschiedenen Ausgestaltungen von Bedeutung sein.

## Patentansprüche

1. Verdampferzelle (100), die zur Verdampfung von Verdampfungsgut eingerichtet ist, umfassend:
- einen Tiegel (10) zur Aufnahme des Verdampfungsguts, der einen Tiegelboden (11), eine Seitenwand (12), die sich in einer Axialrichtung des Tiegels (10) erstreckt, und eine Tiegelöffnung (13) aufweist, und
- eine Heizeinrichtung (20) mit einem Heizwiderstand (21), der eine Vielzahl von Heizbereichen (21.1, 21.2) umfasst, die auf einer Außenseite des Tiegels (10) angeordnet sind und sich entlang der Axialrichtung des Tiegels (10) erstrecken, wobei
- die Heizbereiche (21.1, 21.2) zur mehrseitigen Widerstandsheizung und zur Elektronenstrahlheizung des Tiegels (10) eingerichtet sind, wobei für die Elektronenstrahlheizung die Temperatur der Heizbereiche (21.1, 21.2) durch die Widerstandsheizung erhöht werden kann, bis eine Elektronenemission von den Heizbereichen (21.1, 21.2) einsetzt,
**dadurch gekennzeichnet, dass**
- die Heizbereiche (21.1, 21.2) so gebildet sind, dass ein Heizstrom durch den Heizwiderstand (21) durch alle Heizbereiche (21.1, 21.2) parallel und gleichsinnig fließt.

2. Verdampferzelle nach Anspruch 1, bei der die Heizbereiche getrennte Heizelemente (21.1) umfassen, die parallel geschaltet sind, und/oder zu einem flächigen Widerstandsmaterial verbunden sind, das eine Widerstandshülse (21.2) bildet, und/oder
- der Tiegel (10) und der Heizwiderstand (21) aus Tantal bestehen.

3. Verdampferzelle nach Anspruch 2, bei der
- die Heizeinrichtung (20) einen oberen Ringleiter (22.1), der den Tiegel (10) bei der Tiegelöffnung (13) umgibt und an den die Heizelemente (21.1) parallel angeschlossen sind, und/oder einen unteren Ringleiter (22.2) aufweist, der den Tiegel (10) bei dem Tiegelboden (11) umgibt und an den die Heizelemente (21.1) parallel angeschlossen sind,
- die Widerstandshülse (21.2) an einem oberen Rand, der den Tiegel (10) bei der Tiegelöffnung (13) umgibt, und/oder an einem unteren Rand, der den Tiegel (10) bei dem Tiegelboden (11) umgibt, in radialer Richtung nach außen gekrümmte Streifen (21.4) aufweist, die zur Befestigung der Widerstandshülse (21.2) vorgesehen sind,
- die Heizbereiche (21.2) entlang der Axialrichtung des Tiegels (10) eine konstante Dicke aufweisen,
- die Heizbereiche (21.2) eine Metallfolie umfassen, und/oder
- der Heizwiderstand (21) über einen elektrischen Isolator (14) mit dem Tiegel (10) oder einer Halteeinrichtung (40) des Tiegels (10) oder dem Tiegelboden (11) verbunden ist.

4. Verdampferzelle nach Anspruch 3, bei der
- der untere Ringleiter (22.2) mit dem elektrischen Isolator (14) verbunden ist.

5. Verdampferzelle nach mindestens einem der vorhergehenden Ansprüche, bei der
- eine Abschirmeinrichtung (50) vorgesehen ist, die eine Abschirmwand (51) aufweist, die den Tiegel (10) radial umgibt, wobei der Heizwiderstand (21) bei der Tiegelöffnung (13) elektrisch mit der Abschirmwand (51) verbunden ist, und/oder.
- der Heizwiderstand (21) bei der Tiegelöffnung (13) einen größeren oder einen geringeren radialen Abstand von der Seitenwand (12) aufweist als bei dem Tiegelboden (11).

6. Verdampferzelle nach Anspruch 5, bei der
- der Heizwiderstand (21) an der Abschirmwand (51) befestigt ist, und/oder
- die Abschirmwand (51) aus Tantal besteht.

7. Verdampferzelle nach mindestens einem der vorhergehenden Ansprüche, bei der
- eine Temperaturmesseinrichtung (30) vorgesehen ist, mit der eine Betriebstemperatur der Verdampferzelle messbar ist und die mindestens eines von einem Thermoelement (31), einem Bolometerelement und einem Pyrometerelement umfasst, und/oder
- eine Regeleinrichtung (60) zur Einstellung der Heizeinrichtung (20) vorgesehen ist.

8. Verdampferzelle nach Anspruch 7, bei der
- das Thermoelement (31) ein gerades Bauteil umfasst, das sich entlang der Axialrichtung des Tiegels (10) erstreckt und auf einer Unterseite des Tiegelbodens (11) entlang der Axialrichtung des Tiegels (10) verschiebbar angeordnet ist,
- die Regeleinrichtung (60) einen ersten Regelkreis (61) zur Einstellung eines Widerstands-Heizbetriebs und einen zweiten Regelkreis (62) zur Einstellung eines Elektronenstrahl-Heizbetriebs aufweist, und/oder
- die Regeleinrichtung (60) einen einzigen Regelkreis (61) aufweist, mit dem in einem unteren Temperaturbereich ein Widerstands-Heizbetrieb und in einem oberen Temperaturbereich ein Elektronenstrahl-Heizbetrieb einstellbar ist.

9. Verdampferzelle nach Anspruch 8, bei der
- der Regelkreis (61) für eine Spannungsregelung der Heizeinrichtung (20) und/oder für eine Temperatur-Emissionsregelung der Elektronenstrahlheizung eingerichtet ist.

10. Verfahren zur Verdampfung von Verdampfungsgut mit einer Verdampferzelle nach mindestens einem der vorhergehenden Ansprüche, mit den Schritten:
- Heizung des Verdampfungsguts im Tiegel (10) in einem unteren Temperaturbereich mit einem Widerstands-Heizbetrieb, und
- Heizung des Verdampfungsguts im Tiegel (10) in einem oberen Temperaturbereich mit einem Elektronenstrahl-Heizbetrieb.

11. Verfahren nach Anspruch 10, mit dem Schritt
- Einstellung der Heizeinrichtung (20) mit einer Regeleinrichtung (60).

12. Verfahren nach Anspruch 11, bei dem
- mit einem ersten Regelkreis (61) der Regeleinrichtung (60) der Widerstands-Heizbetriebs und mit einem zweiten Regelkreis (62) der Regeleinrichtung (60) der Elektronenstrahl-Heizbetrieb eingestellt wird, und/oder
- mit einem einzigen Regelkreis (61) der Regeleinrichtung (60) der Widerstands-Heizbetriebs und der Elektronenstrahl-Heizbetrieb eingestellt wird.

13. Verfahren nach Anspruch 12, bei dem
- eine Spannungsregelung der Heizeinrichtung (20) mit dem einzigen Regelkreis (61) und/oder eine Temperatur-Emissionsregelung der Elektronenstrahlheizung vorgesehen ist.

14. Verfahren nach mindestens einem der Ansprüche 10 bis 13, bei dem
- das Verdampfungsgut ein Oxid eines Seltenerdelements enthält, das aus einem Tiegel (10) verdampft wird, der aus Tantal besteht.

15. Verwendung einer Verdampferzelle nach mindestens einem der Ansprüche 1 bis 9 als Dampfquelle in einer Beschichtungsanlage.

## Claims

1. An evaporator cell (100), which is adapted for the evaporation of an evaporant, comprising:
- a crucible (10) for accomodating the evaporant, which has a crucible bottom (11), a side wall (12), which extends in an axial direction of the crucible (10), and a crucible opening (13), and
- a heating device (20) with a heating resistor (21), which comprises a plurality of heating zones (21.1, 21.2), which are arranged on an outside surface of the crucible (10) and extend axially along the crucible (10), wherein
- the heating zones (21.1, 21.2) are adapted for multilateral resistance heating and electron beam heating of the crucible (10), wherein for the electron beam heating the temperature of the heating zones (21.1, 21.2) can be increased by the resistance heating, until an emission of electrons from the heating zones (21.1, 21.2) starts,
**characterized in that**
- the heating zones (21.1, 21.2) are formed in such a way that a heating current through the heating resistor (21) flows in parallel and in the same sense through all heating zones (21.1, 21.2).

2. The evaporator cell according to Claim 1, in which
- the heating zones comprise separate heating elements (21.1), which are connected in parallel and/or are connected as a planar resistance material, which forms a resistance sleeve (21.2), and/or
- the crucible (10) and the heating resistor (21) consist of tantalum.

3. The evaporator cell according to Claim 2, in which
- the heating device (20) has an upper ring-shaped conductor (22.1), which surrounds the crucible (10) at the crucible opening (13) and to which the heating elements (21.1) are connected in parallel, and/or a lower ring-shaped conductor (22.2), which surrounds the crucible (10) at the crucible bottom (11) and to which the heating elements (21.1) are connected in parallel,
- the resistance sleeve (21.2) has, on a top edge, which surrounds the crucible (10) at the crucible opening (13), and/or on a bottom edge, which surrounds the crucible (10) at the crucible bottom (11), strips (21.4) curved outwards in the radial direction, which are provided for securing the resistance sleeve (21.2),
- the heating zones (21.2) have a constant thickness along the axial direction of the crucible (10),
- the heating zones (21.2) comprise a metal foil, and/or
- the heating resistor (21) is connected via an electrical insulator (14) to the crucible (10) or a holding device (40) of the crucible (10) or the crucible bottom (11).

4. The evaporator cell according to Claim 3, in which
- the lower ring-shaped conductor (22.2) is connected to the electrical insulator (14).

5. The evaporator cell according to at least one of the preceding claims, in which
- a shielding device (50) is provided, which has a shielding wall (51), which surrounds the crucible (10) radially, wherein the heating resistor (21) is connected electrically to the shielding wall (51) at the crucible opening (13), and/or
- the heating resistor (21) has a larger or a smaller radial distance from the side wall (12) at the crucible opening (13) than at the crucible bottom (11).

6. The evaporator cell according to Claim 5, in which
- the heating resistor (21) is secured at the shielding wall (51), and/or
- the shielding wall (51) consists of tantalum.

7. The evaporator cell according to at least one of the preceding claims, in which
- a temperature measuring device (30) is provided, with which an operating temperature of the evaporator cell can be measured and which comprises at least one of a thermocouple (31), a bolometer element and a pyrometer element, and/or
- a control device (60) is provided for adjusting the heating device (20).

8. The evaporator cell according to Claim 7, in which
- the thermocouple (31) comprises a straight component, which extends axially along the crucible (10) and is arranged on an underside of the crucible bottom (11) movable axially along the crucible (10),
- the control device (60) has a first control circuit (61) for setting resistance heating and a second control circuit (62) for setting electron beam heating, and/or
- the control device (60) has one single control circuit (61), with which resistance heating can be set in a lower temperature range and electron beam heating can be set in an upper temperature range.

9. The evaporator cell according to Claim 8, in which
- the control circuit (61) is adapted for voltage regulation of the heating device (20) and/or for temperature-emission control of the electron beam heating.

10. A method of evaporation of an evaporant with an evaporator cell according to at least one of the preceding claims, with the steps:
- heating of the evaporant in the crucible (10) in a lower temperature range with resistance heating, and
- heating of the evaporant in the crucible (10) in an upper temperature range with electron beam heating.

11. The method according to Claim 10, with the step
- setting of the heating device (20) with a control device (60).

12. The method according to Claim 11, in which
- operation as resistance heating is set with a first control circuit (61) of the control device (60) and operation as electron beam heating is set with a second control circuit (62) of the control device (60), and/or
- resistance heating operation and electron beam heating operation are set with one single control circuit (61) of the control device (60).

13. The method according to Claim 12, in which
- voltage regulation of the heating device (20) is provided with the single control circuit (61), and/or temperature-emission control of the electron beam heating is provided.

14. The method according to at least one of Claims 10 to 13, in which
- the evaporant contains an oxide of a rare-earth element, which is evaporated from a crucible (10), which consists of tantalum.

15. Use of an evaporator cell according to at least one of Claims 1 to 9 as the source of vapour in a coating installation.

## Revendications

1. Cellule d'évaporation (100) prévue pour l'évaporation d'un produit d'évaporation, comprenant :
- un creuset (10) destiné à recevoir le produit d'évaporation, comportant un fond (11) de creuset, une paroi latérale (12) qui s'étend dans une direction axiale du creuset (10), et une ouverture (13) de creuset, et
- un dispositif de chauffage (20) avec une résistance de chauffage (21) comprenant une pluralité de zones chauffantes (21.1, 21.2) qui sont disposées sur une face extérieure du creuset (10) et s'étendent dans la direction axiale du creuset (10),
- les zones chauffantes (21.1, 21.2) étant prévues pour obtenir un chauffage ohmique sur tous les côtés et/ou un chauffage par faisceau électronique du creuset (10), la température des zones chauffantes (21.1, 21.2) pouvant être élevée par le chauffage ohmique pour le chauffage par faisceau électronique, jusqu'à l'émission d'électrons par les zones chauffantes (21.1, 21.2),
**caractérisée en ce que**
- les zones chauffantes (21.1, 21.2) sont formées de telle sorte qu'un courant de chauffage s'écoule en parallèle et dans une même direction au travers de toutes les zones chauffantes (21.1, 21.2) en passant par la résistance de chauffage (21).

2. Cellule d'évaporation selon la revendication 1, où les zones chauffantes comprennent des éléments chauffants (21.1) séparés qui sont montés en parallèle, et/ou qui sont reliés en matériau résistant mince formant une gaine résistante (21.2), et/ou
- le creuset (10) et la résistance de chauffage (21) sont en tantale.

3. Cellule d'évaporation selon la revendication 2, où
- le dispositif de chauffage (20) comporte un conducteur annulaire supérieur (22.1) qui entoure le creuset (10) sur l'ouverture (13) de creuset et auquel les éléments chauffants (21.1) sont raccordés en parallèle, et/ou un conducteur annulaire inférieur (22.2) qui entoure le creuset (10) sur le fond (11) de creuset et auquel les éléments chauffants (21.1) sont raccordés en parallèle,
- la gaine résistante (21.2) comporte, sur un bord supérieur qui entoure le creuset (10) où l'ouverture (13) de creuset, et/ou sur un bord inférieur qui entoure le creuset (10) sur le fond (11) de creuset, des bandes (21.4) recourbées vers l'extérieur en direction radiale, lesquelles sont prévues pour la fixation de la gaine résistante (21.2),
- les zones chauffantes (21.2) présentent une épaisseur constante en direction axiale du creuset (10),
- les zones chauffantes (21.2) comprennent un film métallique, et/ou
- la résistance de chauffage (21) est reliée par un isolant électrique (14) au creuset (10) ou à un dispositif de maintien (40) du creuset (10) ou du fond (11) du creuset.

4. Cellule d'évaporation selon la revendication 3, où
- le conducteur annulaire inférieur (22.2) est relié à l'isolant électrique (14).

5. Cellule d'évaporation selon au moins une des revendications précédentes, où
- il est prévu un dispositif de blindage (50) comportant une paroi de blindage (51) qui entoure radialement le creuset (10), la résistance de chauffage (21) étant électriquement raccordée à la paroi de blindage (51) sur l'ouverture (13) de creuset, et/ou
- la résistance de chauffage (21) présente sur l'ouverture (13) de creuset une distance radiale à la paroi latérale (12) supérieure à celle sur le fond (11) de creuset.

6. Cellule d'évaporation selon la revendication 5, où
- la résistance de chauffage (21) est fixée sur la paroi de blindage (51), et/ou
- la paroi de blindage (51) est en tantale.

7. Cellule d'évaporation selon au moins une des revendications précédentes, où
- il est prévu un dispositif de mesure de température (30) au moyen duquel une température de service peut être mesurée dans la cellule d'évaporation et, qui comprend au moins un élément parmi un thermoélément (31), un élément bolométrique et un élément pyrométrique, et/ou
- il est prévu un dispositif de régulation (60) pour le réglage du dispositif de chauffage (20).

8. Cellule d'évaporation selon la revendication 7, où
- le thermoélément (31) comprend un composant droit qui s'étend dans la direction axiale du creuset (10) et est disposé de manière à pouvoir être déplacé dans la direction axiale du creuset (10) sur une face inférieure du fond (11) de creuset,
- le dispositif de régulation (60) comporte un premier circuit de régulation (61) pour le réglage d'un mode de chauffage ohmique et un deuxième circuit de régulation (62) pour le réglage d'un mode de chauffage par faisceau électronique, et/ou
- le dispositif de régulation (60) comporte un circuit de régulation unique (61) au moyen duquel un mode de chauffage ohmique peut être réglé dans une plage de température basse, et un mode de chauffage par faisceau électronique dans une plage de température haute.

9. Cellule d'évaporation selon la revendication 8, où
- le circuit de régulation (61) est prévu pour une régulation de tension du dispositif de chauffage (20) et/ou pour une régulation d'émission de température du chauffage par faisceau électronique.

10. Procédé pour l'évaporation d'un produit d'évaporation avec une cellule d'évaporation selon au moins une des revendications précédentes, comprenant les étapes de :
- chauffage du produit d'évaporation dans le creuset (10) dans une plage de température inférieure avec un mode de chauffage ohmique, et de
- chauffage du produit d'évaporation dans le creuset (10) dans une plage de température supérieure avec un mode de chauffage par faisceau électronique.

11. Procédé selon la revendication 10, comprenant l'étape de :
- réglage du dispositif de chauffage (20) au moyen d'un dispositif de régulation (60).

12. Procédé selon la revendication 11, où
- le mode de chauffage ohmique est réglé au moyen d'un premier circuit de régulation (61) du dispositif de régulation (60) et où le mode de chauffage par faisceau électronique est réglé au moyen d'un deuxième circuit de régulation (62) du dispositif de régulation (60), et/ou
- le mode de chauffage ohmique et le mode de chauffage par faisceau électronique sont réglés au moyen d'un circuit de régulation unique (61) du dispositif de régulation (60).

13. Procédé selon la revendication 12, où
- il est prévu une régulation de tension du dispositif de chauffage (20) au moyen du circuit de régulation unique (61) et/ou il est prévu une régulation d'émission de température du chauffage par faisceau électronique.

14. Procédé selon au moins une des revendications 10 à 13, où
- le produit d'évaporation contient un oxyde d'un élément de terre rare, qui est évaporé d'un creuset (10) en tantale.

15. Utilisation d'une cellule d'évaporation selon au moins une des revendications 1 à 9 comme source de vapeur dans une installation de revêtement.
